Europäisches Patentamt

European Patent Office

Office européen des brevets

(19)

(11) Publication number: 0 242 484
A2

# (12) EUROPEAN PATENT APPLICATION

(21) Application number: 86310147.3

(22) Date of filing: 24.12.86

(51) Int. Cl.4: H05K 9/00

(30) Priority: 23.04.86 US 855532

(43) Date of publication of application:
28.10.87 Bulletin 87/44

(84) Designated Contracting States:
DE FR GB NL

(71) Applicant: TEKTRONIX, INC.
Tektronix Industrial Park D/S Y3-121 4900
S.W. Griffith Drive P.O. Box 500
Beaverton Oregon 97077(US)

(72) Inventor: Lynch, Peter D.
2115 S.E. Taylor
Portland Oregon 97214(US)
Inventor: Ator, Patrick
11605 N.W. Melody Lane
Portland Oregon 97214(US)
Inventor: Trobough, Douglas W.
7191 S.W. 161st Place
Beaverton Oregon 97007(US)
Inventor: Varuska, Stanley M.
6305 N.W. Canyonview Road
Gaston Oregon 97119(US)

(74) Representative: Burke, Steven David et al
R.G.C. Jenkins & Co. 12-15, Fetter Lane
London EC4A 1PL(GB)

(54) Electrical assembly having shielded structural sub-parts.

(57) Sub-parts located within an electronic assembly
are electroplated with an alloy of nickel and iron to
shield the interior regions of such sub-parts from
external magnetic fields or to confine the effect of
internal magnetic fields to those regions. The alloy
formed on the sub-part comprises 80 parts by
weight nickel and 20 parts by weight iron. This alloy
results from immersion of the sub-part in a bath
which is 12-14 parts nickel and 1 part iron by weight
and which includes a brightener which is 4% by
volume.

# ELECTRONIC ASSEMBLY HAVING SHIELDED STRUCTURAL SUB-PARTS

## BACKGROUND OF THE INVENTION

The following invention relates to a method and apparatus for shielding the structural sub-parts of electronic assemblies wherein it is desired to remove from the interior of such sub-parts the effects of external magnetic fields or to confine internal magnetic fields to the interior of such sub-parts.

Electronic instrumentation usually consists of a chassis or subassembly having structural sub-parts which may be subjected to magnetic fields of varying intensity. Moreover, such sub-parts may serve as conduits for wiring or as housings for other devices which have strong magnetic fields associated with them. In such cases, it is necessary to shield such structural sub-parts from the effects of such external or internal magnetic fields.

In the past, such shielding has usually taken the form of sheet metal such as mu metal which must be conformed to the external shape of the structural subpart which is required to be shielded. The fact that such metal comes in sheets makes it difficult to shield irregularly shaped sub-parts, and moreover, mu metal is expensive. There will necessarily be waste of the metal due to the fact that sheet metal frequently overlaps and must be cut to fit the desired sub-part, thereby leaving surplus scraps which are discarded as waste. Moreover, mu metal or any sheet metal, since it is difficult to conform exactly to the shape of the sub-part to be shielded, takes up valuable space which can be at a premium inside a complex electronic component or subassembly.

## SUMMARY OF THE INVENTION

The aforementioned problems are solved by the present invention in which structural sub-parts located within an electronic assembly include an outer layer of nickel/iron plating, formed by electroplating, on the structural sub-part substantially enclosing a region within the sub-part which is either to be protected from the influence of an external magnetic field, or to confine to the region an internal magnetic field, thus protecting the remaining portions of the electronic assembly from its influence. The alloy, which is electroplated onto the structural sub-part, is formed of 80 parts by weight nickel and 20 parts by weight iron. A particular advantage of this technique is the ability to electroplate an interior surface of the structural sub-part, such that the sub-part is electroplated with two layers of the nickel-iron alloy, thus forming a doubly protective shielding.

It is a principal object of this invention to provide a means of shielding the structural sub-parts of an electronic assembly from the effects of an internal or external magnetic field efficiently and inexpensively.

Yet a further object of this invention is the shielding of structural sub-parts of an electronic assembly by electroplating the exterior and/or interior surfaces of such sub-parts with a nickel-iron alloy.

The foregoing and other objectives, features and advantages of the present invention will be more readily understood upon consideration of the following detailed description of the invention taken in conjunction with the accompanying drawings.

## BRIEF DESCRIPTION OF THE DRAWINGS

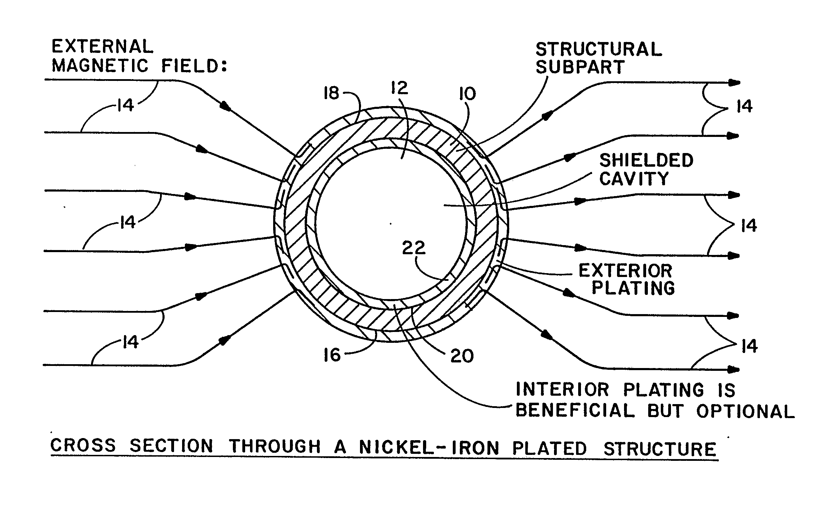

FIG. 1 is a cross sectional view of a structural sub-part of an electronic assembly having electroplated inner and outer surfaces.

## DETAILED DESCRIPTION OF THE DRAWINGS

A structural sub-part 10 of an electronic assembly (not shown) includes an interior region 12 which is to be shielded from the effects of an external magnetic field indicated generally by lines of magnetic flux 14. The outside of the structural sub-part 10 includes a layer of exterior plating 16 which is formed by electroplating the outer surface 18 of the sub-part 10 with a nickel-iron alloy. The structural sub-part 10 also includes an inner surface 20 which may likewise be electroplated with a layer of a nickel-iron alloy 22, if desired.

The nickel-iron plating is highly permeable to magnetic fields, thus causing the lines of magnetic flux 14 to be concentrated in the nickel-iron exterior plate 16, thereby shielding the interior region 12 from the effects of the external magnetic field. The layer of interior plating 22 may further aid the shielding of the interior region 12 depending upon the strength of the magnetic field encountered.

Structural sub-part 10 could comprise any subcomponent or housing such as a conduit for wiring or the housing of a transformer or other electronic component, and could be formed of plastic, aluminum or the like.

The structural sub-parts such as sub-part 10 are electroplated by immersing a desired surface thereof in a bath which preferably comprises nickel and iron in a ratio by weight of 12-14 parts nickel to 1 part iron. To this bath is added a brightener which should comprise approximately 4% of the bath by volume and a levelling agent which should comprise 3% by volume. This results in a deposit on the sub-part 10 of an alloy of 80 parts by weight nickel to 20 parts by weight iron within a tolerance range of ±3%.

The bath is prepared by mixing 20 oz/gal $NiSO_4 \bullet 7H_2O$, 16 oz/gal $NiCl_2 \bullet 6 H_2O$, 6 oz/gal Boric acid and 15 g/l of a stabilizer. Next, 3.9 oz/gal $FeSO_4$ is added plus one fourth of the brightener. The mixture is then dummied by inserting a corrugated iron plate and subjecting the plate to 2 amps/ft$^2$ of current for a period of 6 hours. After the bath has been dummied, it is filtered through a 15 micron filter and the remaining brightener, the levelling agent, and a wetting agent are added. The levelling agent should comprise 3% of the mixture by volume and the wetting agent should comprise .2% by volume. Finally, the pH of the bath is adjusted to 3 using sodium bicarbonate or sulfuric acid as additives.

It has been found that for optimum results the critical proportions are 12-14 parts nickel to 1 part iron with 4% brightener and 3% levelling agent by volume. The brightener, levelling agent, stabilizer and wetting agent are available under the trademark NIRON and are produced by Selrex Udylite Company of Warren, Michigan.

The terms and expressions which have been employed in the foregoing specification are used therein as terms of description and not of limitation, and there is no intention, in the use of such terms and expressions, of excluding equivalents of the features shown and described or portions thereof, it being recognized that the scope of the invention is defined and limited only by the claims which follow.

## Claims

1. In an electronic assembly, a structural sub-part including an outer layer of nickel-iron plating formed on said structural sub-part substantially enclosing an interior region of sub-part whereby said interior region is protected from the influence of an external magnetic field, and wherein internal magnetic fields located within said region are confined to the interior of said sub-part.

2. The structural sub-part of claim 1 wherein said nickel/iron plating is an alloy including approximately 80 parts by weight of nickel and 20 parts by weight of iron.

3. The structural sub-part of claim 1 further including an inner layer of nickel/iron plating formed on an interior surface of said sub-part.

4. A method of shielding a structural sub-part of an electronic assembly from the effects of internal and/or external magnetic fields comprising the step of electroplating said sub-part with a nickel-iron alloy.

5. The method of claim 4 wherein said sub-part is electroplated by immersing a surface of said sub-part in a bath comprising a ratio by weight of 12-14 parts nickel to 1 part iron.

6. The method of claim 5 wherein said bath includes a brightener in the proportion of 4% by volume, and a levelling agent in the proportion of 3% by volume.

EXTERNAL MAGNETIC FIELD:

STRUCTURAL SUBPART

SHIELDED CAVITY

EXTERIOR PLATING

INTERIOR PLATING IS BENEFICIAL BUT OPTIONAL

CROSS SECTION THROUGH A NICKEL-IRON PLATED STRUCTURE